Europäisches Patentamt

European Patent Office

Office européen des brevets

(11) Publication number: **0 268 595 B1**

## EUROPEAN PATENT SPECIFICATION

(45) Date of publication of patent specification: **10.06.92** (51) Int. Cl.5: **G03F 7/30**

(21) Application number: **87902235.8**

(22) Date of filing: **04.03.87**

(86) International application number:
**PCT/US87/00512**

(87) International publication number:
**WO 87/06029 (08.10.87 87/22)**

(54) PATTERN TRANSFER PROCESS FOR FABRICATING INTEGRATED-CIRCUIT DEVICES.

(30) Priority: **24.03.86 US 843242**

(43) Date of publication of application:
**01.06.88 Bulletin 88/22**

(45) Publication of the grant of the patent:
**10.06.92 Bulletin 92/24**

(84) Designated Contracting States:
**FR GB IT NL**

(56) References cited:
**EP-A- 0 100 736**
**US-A- 4 244 799**
**US-A- 4 362 598**

**Patent Abstracts of Japan, volume 9, no. 262 (P-398)(1985), 19 October 1985, & JP-A-60111243**

**VLSI Electronics: Microstructure Science, volume 8, 1984, Academic Press, Inc., J.B. Kruger et al.: "Trilayer resist", pages 91-136, chapter 5**

(73) Proprietor: **AMERICAN TELEPHONE AND TELEGRAPH COMPANY**
**550 Madison Avenue**
**New York, NY 10022(US)**

(72) Inventor: **MANSFIELD, William, Michael**
**618 Hort Street**
**Westfield, NJ 07090(US)**
Inventor: **VAIDYA, Sheila**
**170 Washington Drive**
**Watchung, NJ 07060(US)**

(74) Representative: **Johnston, Kenneth Graham et al**
**AT&T (UK) LTD. AT&T Intellectual Property Division 5 Mornington Road**
**Woodford Green Essex, IG8 OTU(GB)**

Rank Xerox (UK) Business Services

International Electron Devices Meeting, (Washington, D.C., US), 8-10 December 1980, R.K. Watts et al.: "Electron beam lithography for small MOSFETs" pages 772-775

Patent Abstracts of Japan, volume 7, no. 83 (C-160)(1223), 7 April 1983, & JP-A-5811786

## Description

### Background of the Invention

This invention relates to the manufacture of integrated-circuit devices and, more particularly, to a method for transferring a pattern defined in resist into an underlying layer of a device structure.

Increasing miniaturization of semiconductor integrated-circuit devices is the basis for reduced unit cost per function and for improved performance. Feature sizes in very-large-scale-integrated (VLSI) devices thus continue to get smaller.

As feature sizes of VLSI devices decrease, processing requirements for fabricating the devices become more critical. These requirements include the availability of resists characterized by extremely high sensitivity and resolution. Moreover, for improved resolution and linewidth control, such resists must in many cases of be included in a so-called trilevel structure of the type described in U. S. Patent No. 4,244,799 and in "High Resolution, Steep Profile, Resist Patterns" by J. M. Moran and D. Maydan, The Bell System Technical Journal, Vol. 58, No. 5, May-June 1979, pages 1027-1036. Such a structure typically includes a top resist layer, an intermediate masking layer made, for example, of silicon dioxide and a bottom planarizing layer. In such a trilevel structure, pattern transfer from the resist must typically be done by anisotropic dry etching techniques.

A number of negative and positive resists having the requisite sensitivity and resolution for VLSI device fabrication are known. One particularly attractive electron-sensitive positive resist is a material known as Poly(Butene-1 Sulfone) (PBS), which is described by M. J. Bowden and L. F. Thompson in "Electron Irradiation of Poly(olefin Sulfones) Application to Electron Beam Resists," Journal of Applied Polymer Science, Vol. 17, pp. 3211-3221 (1973). Unfortunately, however, PBS and a number of other known resists otherwise suitable for VLSI device fabrication exhibit extremely poor resistance to dry etching. Thus, these resists have been generally regarded as not suitable for utilization in standard processes involving dry etching. In particular, these resists have therefore not been considered feasible for inclusion in trilevel structures. The present invention enables the utilization in a trilevel pattern transfer process of resists that exhibit poor dry etching characteristics.

U.S. Patent 4,362,598 describes a trilevel resist with a metallic intermediate layer.

Patent Abstracts of Japan 60-111 243 discloses another form of trilevel resist.

According to the present invention there is provided a method as defined in claim 1.

A thin layer of a wet-etchable metal (such as chromium) is utilized as the intermediate layer directly underlying PBS in the modified structure. PBS exhibits good resistance to wet etching. Patterns defined in PBS can therefore be transferred into the metal layer in an isotropic wet-etching step. Since the metal layer is extremely thin, the isotropic nature of the wet-etching step does not in practice substantially degrade line-edge quality. The pattern thus formed in the metal layer is therefore a highly accurate replica of the resist pattern. The patterned metal layer then serves as a robust mask for dry etching the underlying planarizing layer of the trilevel structure.

### Brief Description of the Drawing

FIG. 1 is a representative showing of a conventional trilevel structure of the type utilized to fabricate integrated-circuit devices; and

FIG. 2 depicts a variation of the FIG. 1 structure as modified in accordance with the principles of the present invention.

### Detailed Description

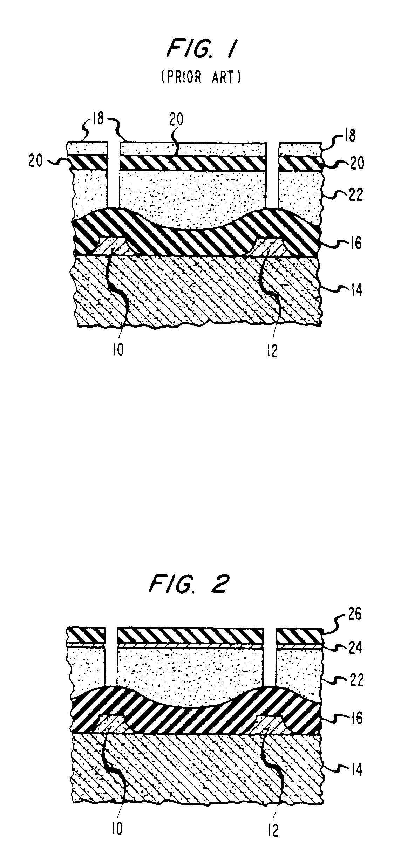

FIG. 1 represents a portion of a standard integrated-circuit device that comprises conductive elements 10 and 12 disposed on a substrate 14. Deposited on the top surface of the substrate 14 and covering the elements 10 and 12 is a layer 16 made of a conventional dielectric material such as p-doped glass.

In accordance with standard steps of a known device fabrication sequence, openings or windows are to be formed in the layer 16 of FIG. 1 in aligned registry with the underlying conductive elements 10 and 12. A conductive material such as aluminum will then be deposited on the top surface of the device and in the aligned windows to establish electrical connections from an upper level of the device structure to the elements 10 and 12.

A trilevel resist structure of the type described in the aforecited Fraser et al patent and Moran et al article is a particularly advantageous way of patterning the layer 16 As indicated in FIG. 1, such a known trilevel structure includes, from top to bottom, layers 18, 20, and 22.

The layer 18 shown in FIG. 1 comprises a positive or negative resist material that can be selectively patterned by, for example, directing light, electrons, X-rays, or ions thereat. A wide variety of such materials are well known in the art. Many standard techniques are available for selectively exposing and developing these materials to form a specified high-resolution pattern in the layer 18.

The intermediate layer 20 in the known structure of FIG. 1 comprises, for example, a 1200-Angstrom-unit (Å)-thick layer of plasma-deposited silicon dioxide. In standard ways, the pattern in the resist layer 18 is transferred into the layer 20 by dry etching techniques. Illustratively, this is done by either plasma or reactive-ion etching the layer 20 with, for example, $CHF_3$, utilizing the patterned layer 18 as a dry-etch-resistant mask therefor.

The planarizing layer 22 shown in the standard structure of FIG. 1 comprises, for example, a relatively thick layer of an organic material. A number of available organic materials are suitable for forming the layer 22. Such materials include a variety of known resists and polyimides. Illustratively, the layer 22 comprises a 1.8-micrometer ($\mu$m)-thick layer of HPR-206 which, after deposition, is, for example, baked for about 20 minutes at approximately 210 degrees Celsius. HPR-206 is a standard positive photoresist commercially available from Philip A. Hunt Chemical Corporation, Palisades Park, New Jersey.

The pattern in the layer 20 of FIG. 1 is transferred into the thick layer 22 in an anisotropic dry etching step. This is done, for example, in a reactive-ion-etching or rf-sputter-etching step utilizing pure oxygen to form a plasma, with the patterned layer 20 acting as a mask. The openings thereby formed in the layer 22 exhibit substantially vertical walls, as indicated in FIG. 1.

A conventional trilevel structure of the type shown in FIG. 1 and described above is an important factor in being able in practice to achieve submicron lithography. Unfortunately, however, as specified earlier above, PBS and a number of other known resists exhibit such poor resistance to dry etching that they have been heretofore considered as not suitable for inclusion in trilevel structures.

In accordance with the the present invention, the intermediate layer 20 of FIG. 1 is replaced with an extremely thin layer made of a wet-etchable metal. When such a material is utilized in conjunction with a resist that exhibits good resistance to wet etching (but poor resistance to dry etching), an effective basis is provided for including otherwise unsuitable resists in a trilevel structure.

A specific illustrative trilevel structure modified in accordance with the principles of the present invention is shown in FIG. 2. Portions of the FIG. 2 structure that may be identical to corresponding portions of FIG. 1 are identified in FIG. 2 with the same reference numerals employed in FIG. 1.

In FIG. 2, reference numeral 24 designates the aforementioned wet-etchable layer. Illustratively, the layer 24 comprises a 300-to-500-Å-thick layer of chromium. By way of example, the layer 24 is deposited on the entire top surface of the layer 22 in a standard sputtering step at a bias of approximately 400 volts dc. In practice, a chromium layer formed in this manner is substantially pin-hole free and exhibits low stress.

Layer 26 overlying the chromium layer 24 of FIG. 2 comprises, for example, a layer of PBS resist. Illustratively, the layer 26 is formed by spin-coating a 4000-Å-thick layer of PBS onto the layer 24 and then baking the coating for about 30 minutes at approximately 120 degrees Celsius.

Subsequently, a prescribed pattern is formed in the resist layer 26 in standard ways known in the art. This is done, for example, by selectively irradiating the resist layer 26 with an electron beam in a direct-writing mode at a current density of about 2.5-to-3 microcoulombs per square centimeter. Standard wet development of the positive resist layer then results in removal of irradiated portions. Postbaking of the developed resist at about 120 degrees Celsius for approximately 30 minutes is then typically carried out. This leaves a patterned resist layer 26, as indicated in FIG. 2.

The presence of a metallic (chromium) layer underlying the resist layer 26 during electron-beam exposure has been found to be advantageous. In practice, such a metallic layer causes the exposure of the resist layer to be more uniform than if the layer underlying the resist were made of, say, silicon dioxide as in a standard trilevel structure. In turn, more uniform exposure leads to better line-edge quality in the final pattern defined in the resist.

Additionally, the presence of the metallic layer 24 in the trilevel structure of FIG. 2 is advantageous because it effectively prevents charge buildup during electron-beam exposure. Such buildup, if allowed to occur, can in practice lead to distortions in the patterned resist image by displacing the writing spot from its expected location. By connecting the metallic layer 24 to a point of reference potential such as ground on, for example, a workpiece holder, charge impinging on the trilevel structure during exposure is prevented from accumulating on the structure.

Another advantageous property of the thin layer 24 described herein is that in practice it is relatively transparent to backscattered signals emanating from standard alignment marks (not shown) formed on the substrate 14. This facilitates conventional level-to-level registration during device fabrication.

The pattern formed in the PBS resist layer 26 of the trilevel structure shown in FIG. 2 is then transferred into the chromium layer 24 in a wet-etching step. Illustratively, this is done by employing a standard solution of water and ceric ammonium nitrate in the approximate ratio of 2-to-1 by volume. This is the conventional chromium wet etch that is widely used in industrial clean-rooms for production fabrication of photomasks.

The aforespecified wet-etching step is isotropic in nature. But, since the chromium layer 24 is so thin (300-to-500 Å), negligible undercutting occurs. In practice, line-edge quality in the pattern transfer process is therefore not substantially degraded.

Subsequently, the patterned chromium layer 24 of FIG. 2 is utilized as a mask for conventional dry etching of the underlying thick layer 22. This is done, for example, in a standard reactive-ion-etching step utilizing an oxygen plasma, as is well known. In that way, substantially vertically walled features are transferred into the thick layer 22, as shown in FIG. 2.

The patterned layer 22 of FIG. 2 is then utilized as a mask for processing of the underlying device structure. In practice, the overall transfer process described herein has been demonstrated to have a 0.25-$\mu$m-resolution capability with excellent image quality.

Other resists that exhibit poor plasma erosion resistance but good resistance to wet etching and that may be used in a trilevel structure in conjunction with an underlying wet-etchable layer include PMPS, FBM-G, EBR-9, etc., as described by T. Tamamura, S. Imamura and S. Sugawara in "Resists for Electron Beam Lithography," Polymers in Electronics, T. Davidson, editor (1984), ACS Symposium Series 242, pp. 103-118. Also, thin layers of wet-etchable materials other than chromium may be employed to form the pattern transfer layer utilized to carry out applicants' inventive process. Examples of such materials are tungsten, aluminum, tantalum, and molybdenum. Additionally, the invention is not limited to pattern transfer processes that involve electron-beam exposure of resists, but is applicable to other exposure processes in which, for example, X-ray lithography is employed to selectively irradiate a wet-etch-resistant resist.

## Claims

1. A pattern-transfer method of fabricating integrated-circuit devices, said method comprising the steps of patterning an electron-beam resist layer (26), using the patterned resist layer as a mask to etch an underlying metallic layer (24) thereby transferring the pattern from the resist layer to the underlying layer, and dry etching a planarizing relatively thick layer (22) under the said underlying layer, thereby transferring the pattern of the resist layer into the planarizing layer, CHARACTERISED IN THAT the resist layer is a high resolution wet-etchant material which exhibits unsatisfactory (relatively-low) resistance to dry etching, and in that the said underlying layer is of approximately 300 to 500 Å thick and is a wet-etchable metal which exhibits satisfactory resistance to dry etching (namely high resistance relative to that of the planarizing layer), thus enabling the pattern in the said underlying layer to be transferred to the planarizing layer by wet etching.

2. A method as in claim 1, CHARACTERISED IN THAT said underlying layer comprises chromium.

3. A method as in claim 2, CHARACTERISED IN THAT said resist layer comprises PBS resist.

4. A method as in claim 3, CHARACTERISED IN THAT said chromium layer is formed in a bias-sputtering step.

5. A method as in claim 4, CHARACTERISED IN THAT said chromium layer is approximately 300-to-500 Å thick.

6. A method as in claim 5, CHARACTERISED IN THAT said chromium layer is wet etched in a 2-to-1 solution of water and ceric ammonium nitrate.

7. A method as in claim 6, CHARACTERISED IN THAT said relatively thick layer is anisotropically dry etched in an oxygen plasma.

## Revendications

1. Un procédé de transfert de motif pour la fabrication de dispositifs à circuits intégrés, ce procédé comprenant les étapes qui consistent à définir un motif dans une couche de matière de réserve sensible à un faisceau d'électrons (26), à utiliser la couche de matière de réserve portant un motif, à titre de masque pour graver une couche métallique sous-jacente (24), et pour transférer ainsi le motif de la couche de matière de réserve à la couche sous-jacente, et à graver par voie sèche une couche d'aplanissement relativement épaisse (22) qui se trouve sous la couche métallique sous-jacente précitée, pour transférer ainsi le motif de la couche de matière de réserve vers la couche d'aplanissement, CARACTERISE EN CE QUE la couche de matière de réserve consiste en une matière pour un agent de gravure par voie humide à résolution élevée, qui présente une résistance non satisfaisante (relativement faible) à la gravure par voie sèche, et en ce que la couche sous-jacente précitée mesure approximativement 300 à 500 Å d'épaisseur et consiste en un métal pouvant être gravé par voie humide, qui présente une résistance satisfaisante à la gravure par voie sèche (c'est-à-dire une résistance élevée par rapport à celle de la couche d'aplanissement), permettant ainsi de transférer vers la couche d'aplanissement, par gravure par voie humide, le motif qui est formé dans la couche sous-jacente précitée.

2. Un procédé selon la revendication 1, CARACTERISE EN CE QUE la couche sous-jacente consiste en chrome.

3. Un procédé selon la revendication 2, CARACTERISE EN CE QUE la couche de matière de réserve consiste en une matière de réserve PBS.

4. Un procédé selon la revendication 3, CARACTERISE EN CE QUE la couche de chrome est formée au cours d'une étape de pulvérisation cathodique avec polarisation.

5. Un procédé selon la revendication 4, CARACTERISE EN CE QUE la couche de chrome mesure approximativement 300 à 500 Å d'épaisseur.

6. Un procédé selon la revendication 5, CARACTERISE EN CE QUE la couche de chrome est gravée par voie humide dans une solution d'eau et de nitrate d'ammonium cérique dans une proportion de 2 à 1.

7. Un procédé selon la revendication 6, CARACTERISE EN CE QUE la couche relativement épaisse est gravée par voie sèche de façon anisotrope dans un plasma d'oxygène.

**Patentansprüche**

1. Musterübertragungsverfahren zur Herstellung integrierter Schaltungsbauteile mit den Verfahrensschritten:
Musterbearbeitung einer Elektronenstrahl-Resistschicht (26) unter Verwendung der gemusterten Resistschicht als Maske zur Ätzung einer darunterliegenden Metallschicht (24), wodurch das Muster von der Resistschicht auf die darunterliegende Metallschicht übertragen wird, und Trockenätzen einer verhältnismäßig dicken Einebnungsschicht (22) unter der Metallschicht, wodurch das Muster der Resistschicht in die Einebnungsschicht übertragen wird,
dadurch gekennzeichnet,
daß die Resistschicht ein hochauflösendes, naß-ätzbares Material ist, das einen ungenügenden (verhältnismäßig niedrigen) Widerstand gegen trockenes Ätzen zeigt, und daß die darunterliegende Metallschicht eine Dicke von etwa 300 bis 500 Å hat und ein naß-ätzbares Metall ist, das einen ausreichenden Widerstand gegen trockenes Ätzen (nämlich einen hohen Widerstand mit Bezug auf den der Einebnungsschicht) besitzt, wodurch das Muster in der darunterliegenden Metallschicht durch nasses Ätzen auf die Einebnungsschicht übertragen werden kann.

2. Verfahren nach Anspruch 1,
dadurch gekennzeichnet,
daß die darunterliegende Metallschicht Chrom umfaßt.

3. Verfahren nach Anspruch 2,
dadurch gekennzeichnet,
daß die Resistschicht ein PBS-Resist umfaßt.

4. Verfahren nach Anspruch 3,
dadurch gekennzeichnet,
daß die Chromschicht durch ein Vorspannungs-Aufstäubungsverfahren erzeugt wird.

5. Verfahren nach Anspruch 4,
dadurch gekennzeichnet,
daß die Chromschicht etwa 300 bis 500 Å dick ist.

6. Verfahren nach Anspruch 5,
dadurch gekennzeichnet,
daß die Chromschicht in einer 2:1-Lösung von Wasser und Cerammoniumnitrad naß geätzt wird.

7. Verfahren nach Anspruch 6,
dadurch gekennzeichnet,
daß die verhältnismäßig dicke Schicht anisotropisch in einem Sauerstoffplasma trocken geätzt wird.

## *FIG. 1*
(PRIOR ART)

## *FIG. 2*